# EUROPÄISCHE PATENTSCHRIFT

(11) **EP 2 183 404 B1**
(45) Veröffentlichungstag und Bekanntmachung des Hinweises auf die Patenterteilung: **05.06.2013**
(21) Anmeldenummer: 08786253.8
(22) Anmeldetag: 18.07.2008
(51) Int. Cl.: C23C 14/06, F16J 9/26, C23C 30/00

(54) **KOLBENRING**
PISTON RING
SEGMENT DE PISTON

(30) Priorität: 28.07.2007 DE 102007035502
(43) Veröffentlichungstag der Anmeldung: 12.05.2010
(73) Patentinhaber: Federal-Mogul Burscheid GmbH, 51399 Burscheid (DE)
(72) Erfinder: HOPPE, Steffen, 51491 Overath (DE); FISCHER, Manfred, 42795 Leichlingen (DE); BAUER, Christiane, 51399 Burscheid (DE); LAMMERS, Ralf, 42929 Wermelskirchen (DE)
(74) Vertreter: Mehler Achler
(86) Internationale Anmeldenummer: PCT/EP2008/059473
(87) Internationale Veröffentlichungsnummer: WO 2009/016051

(56) Entgegenhaltungen:
- EP-A- 1 726 686
- WO-A-2004/059030
- WO-A-2006/084404
- WO-A2-2008/040695
- DE-A1-102004 028 486
- JP-A- 2001 335 878
- JP-A- 2006 037 212
- TIEN ET AL: "Oxidation behavior of sputtered CrN/AlN multilayer coatings during heat treatment" SURFACE AND COATINGS TECHNOLOGY, ELSEVIER, AMSTERDAM, NL, Bd. 201, Nr. 9-11, 31. Januar 2007 (2007-01-31), Seiten 5138-5142, XP005738621 ISSN: 0257-8972

## Beschreibung

Die Erfindung betrifft einen Kolbenring gemäß dem Oberbegriff von Anspruch 1.

Kolbenringe werden mit Verschleißschutzschichten an der Lauffläche und/oder an den Ringflanken versehen, um die geforderte Lebensdauer erfüllen zu können. Höhere Zylinderdrücke, Direkteinspritzungen, Abgasrückführung und andere Konstruktionsmerkmale neuer Motorenentwicklungen, wie alternative Zylinderwerkstoffe, aber auch die Minimierung des Ölverbrauchs belasten die Kolbenringe zunehmend.

Verschleißschutzschichten werden mittels thermischer Spritzverfahren, galvanischer Verfahren oder Dünnschichttechnologien aufgebracht und gegebenenfalls durch Wärmebehandlung und Diffusionsprozesse bearbeitet. Die Schichten werden in der Regel weitgehend homogen und somit unstrukturiert aufgebracht. Die Verschleißbeständigkeit wird durch entsprechende Härte des Materials eingestellt.

Alle Erscheinungsformen, die auf thermische Überbeanspruchung an der Kolbenringfläche hinweisen, werden typischerweise unter dem Begriff Brandspuren zusammengefasst.

Der Begriff Brandspuren wurde ursprünglich über Erscheinungsformen an der Lauffläche von Kolbenringen definiert. Die Verfärbungen und die so genannte "Pflastersteinbildung" auf der Chromoberfläche sind Indizien für eine thermische Überlastung. Erweitert man den Begriff Brandspuren auch auf andere Werkstoffe, dann sind alle Erscheinungsformen, die auf thermische Überbeanspruchung an der Kolbenringlauffläche hinweisen, darunter zu fassen. Die Unterscheidung zwischen Brandspuren und Fressen sind fließend. Beim Fressen sind auf der Oberfläche der Kolbenringe starke Verriefungen und/oder Werkstoffüberträge zu erkennen. Brandspuren und Fresser werden durch metallischen Kontakt der Laufpartner verursacht, der durch Schmierölmangel oder zu hohe Flächenpressung der Kolbenringe eintritt. Undichte, nicht an der Zylinderwand anliegende Kolbenringe und unrunde Zylinder ermöglichen ungewollten Durchtritt der heißen Brenngase (Blow-by-Verluste), wodurch das Schmieröl weggebrannt wird und eine metallische Berührung der Laufpartner eintritt (s. www.motorlexikon.de).

Aus der DE 199 31 829 A1 ist eine galvanische Hartchromschicht bekannt, die Risse aufweist, in die Diamantpartikel mit einer Größe von 0,25 bis 0,5 µm eingelagert sind. Zusätzlich können noch weitere Hartstoffpartikel aus Wolframcarbid, Chromcarbid, Aluminiumoxid, Siliziumcarbid, Siliziumnitrid, Borcarbid oder Bornitrid in die Risse eingelagert sein.

Beim Auftreten hoher Temperaturen wandeln sich die Diamantpartikel in Graphit um, der dann Schmieraufgaben übernimmt und damit die Brandspurbildung verhindert. Somit besitzt diese Schicht auch noch sehr gute Notlaufeigenschaften, insbesondere aufgrund der Umwandlung von Diamant zu Graphit bei Temperaturen von ca. 700°C oder höher.

Um das Brandspurverhalten von Kolbenringen weiter zu verbessern, werden bisher typischerweise Schichten aus Materialien eingesetzt, die sehr hohe Schmelzpunkte haben und für deren thermische Überbeanspruchung folglich hohe Temperaturen erforderlich sind. Ein typisches Beispiel dafür ist mittels PVD-Verfahren aufgebrachtes Chromnitrid mit einer Zersetzungstemperatur von ca. 2000K.

Um die Brandspurfestigkeit und die Verschleißbeständigkeit zu verbessern, wird in der DE 10 2004 028 486 A1 eine Beschichtung aus mehreren Einzellagen vorgeschlagen, die abwechselnd aus Chrom und Chromnitrid bestehen. Die Chromnitridschichten können aus CrN, Cr₂N oder Mischungen hieraus bestehen. Zur Vermeidung schroffer Übergänge wird das Beschichtungsverfahren so gesteuert, dass die Chromnitrid-Einzellagen jeweils beiderseits einen Saum aus Cr₂N und einen Kern aus CrN aufweisen. Jede Einzellage ist mindestens 0,01 µm dick. Die maximale Dicke beträgt 10 µm. Die Gesamtdicke der Beschichtung wird mit 5 bis 100 µm angegeben.

Die WO 2006/084404 A1 offenbart eine verschleißfeste Triplex-Beschichtung u. a. für Kolbenringe. Auf einem Substrat sind drei Schichten aufgebracht, die aus einer Hauptschicht, einer Zwischenschicht und einer äußeren Oberflächenschicht bestehen. Die Oberflächenschicht besteht aus AlCrZ, wobei Z für N, C, B, CN, BN, CBN, NO, CO, BO, CNO, BNO oder CBNO steht.

Die US 5,549,086 offenbart Kolbenringbeschichtungen aus TiN und CrN.

Die DE 10 2004 032 403 B3 beschreibt Kolbenringe, die auf einer Chromhaftschicht eine CrN-Gradientenschicht mit einem nach außen hin zunehmenden Stickstoffgehalt aufweisen.

Aus der JP 2005-060810 A sind Kolbenringe für Verbrennungskraftmaschinen bekannt, die mit einem Viellagenschichtsystem versehen sind, deren Einzellagen dieselbe metallische Komponente aufweisen und sich lediglich im Stickstoffgehalt unterscheiden. Die Schichtdicken der Einzellagen werden mit < 1 µm angegeben. Die Schichten werden mittels eines PVD-Verfahrens, insbesondere eines Lichtbogenverfahrens, aufgebracht.

Die Brandspurfestigkeit der bekannten Schichten ist jedoch nicht zufriedenstellend.

Es ist daher Aufgabe der Erfindung, einen Kolbenring mit einer Verschleißschutzschicht anzugeben, die bei großer Verschleißbeständigkeit auch eine gute Brandspurbeständigkeit aufweist.

Es hat sich herausgestellt, dass Brandspuren dann vermieden werden können, wenn die Wärme möglichst schnell abgeführt wird. Keine oder nur geringe Brandspuren treten auf, wenn ein Material verwendet wird, dessen Wärmeleitfähigkeit mindestens 180 W / (m·K) aufweist.

Gemäß einer ersten Alternative besteht die Verschleißschutzschicht aus einer Einlagenschicht aus einem Dreistoffsystem, wobei die Verschleißschutzschicht aus einem Dreistoffsystem AlMeN besteht, wobei Me ein Element aus der Gruppe Ti, Zr, Hf, V, Nb, Ta, Mo, W, Si und C ist und Al Aluminium und N Stickstoff bedeuten.

Gemäß einer zweiten Alternative besteht die Verschleißschutzschicht aus einem periodisch aufgebauten Viellagenschichtsystem, bei dem jede Periodizität aus mindestens zwei Einzellagen besteht, die sich hinsichtlich ihrer Zusammensetzung unterscheiden.

Vorzugsweise weist das Viellagenschichtsystem Einzellagen aus AlN und aus einem Nitrid der Gruppe Ti, Zr, Hf, V, Nb, Ta, Cr, Mo, W, Si und C auf. Vorzugsweise weist jede Periodizität mindestens eine Einzellage aus AIN auf. Bevorzugt ist eine Periodizität aus zwei Einzellagen, wovon eine Einzellage aus AIN besteht.

Vorzugsweise besteht mindestens eine Einzellage aus einem Nitrid aus mindestens zwei Metallen der genannten Gruppe.

Im Rahmen solcher Viellagenschichtsysteme sind Viellagenschichtsysteme mit Einzellagen aus CrN und AIN bevorzugt. Viellagenschichtsysteme aus Einzellagen mit Chromnitrid und Aluminiumnitrid weisen sogar Wärmeleitfähigkeitswerte von 225 W /(m·K) auf.

Die Dicke einer Einzellage eines solchen Viellagenschichtsystems beträgt vorzugsweise > 15 nm bis 1 µm.

Vorzugsweise beträgt die Dicke einer Einzellage des Viellagenschichtsystem ≥ 2 nm bis 15 nm. Bei derart geringen Dicken entstehen so genannte Übergitterstrukturen. Übergitterstrukturen entstehen durch die gestörte Gitteranordnung in der unmittelbaren Nähe zu dem Gitter der benachbarten Einzellage. Die Einzellagen beeinflussen sich im Grenzbereich, so dass die Gitterparameter dort verändert sind. Aufgrund der relativ großen Dicke der Einzellagen, die beispielsweise durch 7 bis 35 Atomlagen gebildet werden, entsteht in jeder Einzellage ein Kernbereich, in dem sich ein Gitter ausbildet, das dem einer Einlagenschicht entspricht. Dieser Kernbereich wird von einer Übergitterstruktur zu den Lagengrenzen hin gesäumt.

Vorzugsweise besteht die Verschleißschutzschicht aus Aluminiumnitrid mit einem Anteil von mindestens 5 Vol.-%. Weitere bevorzugte Anteile sind mindestens 10 Vol.-%, mindestens 20 Vol.-%, mindestens 30 Vol.-%, insbesondere mindestens 40 Vol.-% und besonders bevorzugt mindestens 50 Vol.-%. Der Volumenprozent-Anteil bezieht sich auf die gesamte Verschleißschutzschicht, unabhängig davon, ob sie aus einer homogenen Einlagenschicht oder aus einem Viellagenschichtsystem besteht.

Die Gesamtdicke der Verschleißschutzschicht sowohl bei Viellagenschichtsystemen als auch bei Einlagenschichten beträgt vorzugsweise ≥ 5 µm. Bevorzugte Gesamtdicken der Verschleißschutzschicht sind 5 µm bis 60 µm, 5 µm bis 15 µm und 25 µm bis 35 µm.

Zwischen dem Trägermaterial und der Verschleißschutzschicht ist vorzugsweise eine Haftschicht aus einem Metall oder einem Nitrid der oben genannten Gruppe Ti, Zr, Hf, V, Nb, Ta, Cr, Mo, W, Si und C angeordnet. Vorzugsweise besteht die Haftschicht aus Chrom.

Vorzugsweise wird die Verschleißschutzschicht mittels eines PVD-Verfahrens, eines reaktiven Lichtbogenverfahrens oder eines CVD-Verfahrens aufgebracht.

Besondere Verwendungen dieser Kolbenringe sind für Ottomotore und Dieselmotore vorgesehen.

### Beispiele:

Ermittlung der Wärmeleitfähigkeit an PVD-Schichten

Zur Messung der Temperaturleitfähigkeit wurde das Grundprinzip des photoakustischen Verfahrens eingesetzt. Dabei wurde die PVD-Schicht einer periodischen Bestrahlung mit Licht ausgesetzt und die Temperaturleitfähigkeit gemessen.

Die Wärmeleitfähigkeit der Probe wird unter Berücksichtigung der Dichte und der spezifischen Wärme berechnet. Die spezifische Wärmekapazität entspricht in dünnen Schichten der des Kompaktmaterials, was für die Dichte jedoch nicht unbedingt zutrifft. Für die Auswertung wurde daher die Dichte des Kompaktmaterials verwendet.

| Schicht | Wärmeleitfähigkeit in W / (m·K) |
|---|---|
| ECD - GDC^{®} | 34,8 ± 2,8 |
| ECD - Cr | 38,5 ± 3,1 |
| PVD - CrN | 170,4 ± 13,6 |
| PVD - CrN / AIN | 225,3 ± 18,2 |

| | |
|---|---|
| ECD: galvanisch abgeschiedene Schicht GDC^{®}: Chromschicht mit Diamant gemäß DE 19931829 A1 | |

Die Wärmeleitfähigkeit von typischen CrN-PVD-Schichten beträgt 170 W / (m·K). Für die PVD-Schichten kann die Wärmeleitfähigkeit von derjenigen des Kompaktmaterials abweichen, da diese Schichten sich nicht zwangsläufig im thermischen Gleichgewicht befinden und typischerweise erhebliche Eigenspannungen vorhanden sind.

Die Wärmeleitfähigkeit eines erfindungsgemäßen Viellagenschichtsystems mit Einzellagen aus CrN und AIN liegt bei 225,3 W / (m·K). Dieses Viellagenschichtsystem weist keinerlei Brandspuren auf.

## Patentansprüche

1. Kolbenring aus einem Trägermaterial, insbesondere aus einem Stahl-oder einem Gusswerkstoff, und mit einer aufgebrachten Verschleißschutzschicht, **dadurch gekennzeichnet, dass** die Verschleißschutzschicht aus Material mit einer Wärmeleitfähigkeit von mindestens 180 W / (m·K) besteht, wobei die Verschleißschutzschicht aus einer Einlagenschicht aus einem Dreistoffsystem Al-Me-N besteht mit Me ein Element aus der Gruppe Ti, Zr, Hf, V, Nb, Ta, Mo, W, Si und C, wobei Al Aluminium und N Stickstoff bedeuten.

2. Kolbenring aus einem Trägermaterial, insbesondere aus einem Stahl-oder einem Gusswerkstoff, und mit einer aufgebrachten Verschleißschutzschicht, **dadurch gekennzeichnet, dass** die Verschleißschutzschicht aus Material mit einer Wärmeleitfähigkeit von mindestens 180 W / (m·K) besteht, wobei die Verschleißschutzschicht aus einem periodisch aufgebauten Viellagenschichtsystem besteht, bei dem jede Periodizität aus mindestens zwei Einzellagen besteht, die sich hinsichtlich ihrer Zusammensetzung unterscheiden.

3. Kolbenring nach Anspruch 2, **dadurch gekennzeichnet, dass** das Viellagenschichtsystem Einzellagen aus AlN und aus einem Nitrid der Gruppe Ti, Zr, Hf, V, Nb, Ta, Cr, Mo, W, Si und C aufweist.

4. Kolbenring nach einem der Ansprüche 2 oder 3, **dadurch gekennzeichnet, dass** mindestens eine Einzellage aus einem Nitrid aus mindestens zwei Elementen der Gruppe Ti, Zr, Hf, V, Nb, Ta, Cr, Mo, W, Si und C besteht.

5. Kolbenring nach einem der Ansprüche 2 bis 4, **dadurch gekennzeichnet, dass** das Viellagenschichtsystem Einzellagen aus CrN und aus AIN aufweist.

6. Kolbenring nach einem der Ansprüche 2 bis 5, **dadurch gekennzeichnet, dass** die Dicke einer Einzellage des Viellagenschichtsystems > 15 nm bis 1 µm beträgt.

7. Kolbenring nach einem der Ansprüche 2 bis 5, **dadurch gekennzeichnet, dass** die Dicke einer Einzellage des Viellagenschichtsystems ≥2 nm bis 15 nm beträgt.

8. Kolbenring nach einem der Ansprüche 1 bis 7, **dadurch gekennzeichnet, dass** mindestens 5 Vol.% der Verschleißschutzschicht, bezogen auf die gesamte Verschleißschutzschicht, aus Aluminiumnitrid bestehen.

9. Kolbenring nach einem der Ansprüche 1 bis 8, **dadurch gekennzeichnet, dass** die Gesamtdicke der Verschleißschutzschicht ≥ 5 µm beträgt.

10. Kolbenring nach einem der Ansprüche 1 bis 9, **dadurch gekennzeichnet, dass** zwischen dem Trägermaterial und der Verschleißschutzschicht eine Haftschicht aus einem Metall oder einem Nitrid der Gruppe Ti, Zr, Hf, V, Nb, Ta, Cr, Mo, W, Si und C angeordnet ist.

11. Kolbenring nach Anspruch 10, **dadurch gekennzeichnet, dass** die Haftschicht aus Cr besteht.

12. Kolbenring nach einem der Ansprüche 1 bis 11, **dadurch gekennzeichnet, dass** die Verschleißschutzschicht mittels eines PVD-Verfahrens aufgebracht wird.

13. Kolbenring nach einem der Ansprüche 1 bis 12, **dadurch gekennzeichnet, dass** die Verschleißschutzschicht mittels eines reaktiven Lichtbogenverfahrens aufgebracht wird.

14. Kolbenring nach einem der Ansprüche 1 bis 13, **dadurch gekennzeichnet, dass** die Verschleißschutzschicht mittels eines CVD-Verfahrens aufgebracht wird.

15. Verwendung eines Kolbenrings mit Verschleißschutzschicht nach einem der Ansprüche 1 bis 14 in Ottomotoren oder in Dieselmotoren.

## Claims

1. A piston ring made of a substrate material, in particular of a steel material or a casting material, and having an applied wear protection coating, **characterised in that** the wear protection coating consists of a material having a thermal conductivity of at least 180 W/(m·K), wherein the wear protection layer consists of a single layer comprising a ternary system Al-Me-N, with Me being an element from the group comprising Ti, Zr, Hf, V, Nb, Ta, Mo, W, Si and C, wherein Al represents aluminium and N represents nitrogen.

2. A piston ring made of a substrate material, in particular of a steel material or a casting material, and having an applied wear protection coating, **characterised in that** the wear protection coating consists of a material having a thermal conductivity of at least 180 W/(m·K), wherein the wear protection layer consists of a periodic multilayer system, in which each periodicity consists of at least two individual layers that differ in respect of the composition thereof.

3. A piston ring according to claim 2, **characterised in that** the multilayer system comprises individual layers of AlN and of a nitride from the group comprising Ti, Zr, Hf, V, Nb, Ta, Cr, Mo, W, Si and C.

4. A piston ring according to any one of claims 2 and 3, **characterised in that** at least one individual layer consists of a nitride from at least two elements of the group Ti, Zr, Hf, V, Nb, Ta, Cr, Mo, W, Si and C.

5. A piston ring according to any one of claims 2 to 4, **characterised in that** the multilayer system comprises individual layers of CrN and of AlN.

6. A piston ring according to any one of claims 2 to 5, **characterised in that** the thickness of an individual layer of the multilayer system > 15 nm to 1 µm.

7. A piston ring according to any one of claims 2 to 5, **characterised in that** the thickness of an individual layer of the multilayer system ≥ 2 nm to 15 nm.

8. A piston ring according to any one of claims 1 to 7, **characterised in that** at least 5% by volume of the wear protection coating, based on the entire wear protection coating, consists of aluminium nitride.

9. A piston ring according to any one of claims 1 to 8, **characterised in that** the total thickness of the wear protection coating ≥ 5 µm.

10. A piston ring according to any one of claims 1 to 9, **characterised in that** a bonding layer made of a metal or a nitride from the group comprising Ti, Zr, Hf, V, Nb, Ta, Cr, Mo, W, Si and C is arranged between the substrate material and the wear protection coating.

11. A piston ring according to claim 10, **characterised in that** the bonding layer consists of Cr.

12. A piston ring according to any one of claims 1 to 11, **characterised in that** the wear protection coating is applied by means of a PVD method.

13. A piston ring according to any one of claims 1 to 12, **characterised in that** the wear protection coating is applied by means of a reactive arc welding method.

14. A piston ring according to any one of claims 1 to 13, **characterised in that** the wear protection coating is applied by means of a CVD method.

15. Use of a piston ring having a wear protection coating according to any one of claims 1 to 14 in Otto engines or diesel engines.

## Revendications

1. Segment de piston constitué d'un matériau support, en particulier d'un matériau à base d'acier ou d'un matériau de moulage, sur lequel est appliquée une couche de protection contre l'usure, **caractérisé en ce que** la couche de protection contre l'usure est constituée d'un matériau ayant une conductivité thermique d'au moins 180 W / (m.K), sachant que la couche de protection contre l'usure est une monocouche en un système ternaire Al-Me-N, où Me est un élément du groupe Ti, Zr, Hf, V, Nb, Ta, Mo, W, Si et C, Al est l'aluminium et N est l'azote.

2. Segment de piston constitué d'un matériau support, en particulier d'un matériau à base d'acier ou d'un matériau de moulage, sur lequel est appliquée une couche de protection contre l'usure, **caractérisé en ce que** la couche de protection contre l'usure est constituée d'un matériau ayant une conductivité thermique d'au moins 180 W / (m.K), sachant que la couche de protection contre l'usure est un système multicouche à structure périodique dans lequel chaque périodicité est constituée d'au moins deux couches individuelles qui se différencient quant à leur composition.

3. Segment de piston selon la revendication 2, **caractérisé en ce que** le système multicouche présente des couches individuelles en AIN et en un nitrure du groupe Ti, Zr, Hf, V, Nb, Ta, Cr, Mo, W, Si et C.

4. Segment de piston selon la revendication 2 ou 3, **caractérisé en ce qu'**au moins une couche individuelle est constituée d'un nitrure d'au moins deux éléments du groupe Ti, Zr, Hf, V, Nb, Ta, Cr, Mo, W, Si et C.

5. Segment de piston selon l'une des revendications 2 à 4, **caractérisé en ce que** le système multicouche présente des couches individuelles en CrN et en AIN.

6. Segment de piston selon l'une des revendications 2 à 5, **caractérisé en ce que** l'épaisseur d'une couche individuelle du système multicouche est > 15 nm jusqu'à 1 µm.

7. Segment de piston selon l'une des revendications 2 à 5, **caractérisé en ce que** l'épaisseur d'une couche individuelle du système multicouche est ≥ 2 nm jusqu'à 15 nm.

8. Segment de piston selon l'une des revendications 1 à 7, **caractérisé en ce qu'**au moins 5% en volume de la couche de protection contre l'usure, rapporté à la totalité de la couche de protection contre l'usure, sont constitués de nitrure d'aluminium.

9. Segment de piston selon l'une des revendications 1 à 8, **caractérisé en ce que** l'épaisseur totale de la couche de protection contre l'usure est ≥ 5 µm.

10. Segment de piston selon l'une des revendications 1 à 9, **caractérisé en ce qu'**une couche d'adhérence en un métal ou en un nitrure du groupe Ti, Zr, Hf, V, Nb, Ta, Cr, Mo, W, Si et C est disposée entre le matériau support et la couche de protection contre l'usure.

11. Segment de piston selon la revendication 10, **caractérisé en ce que** la couche d'adhérence est en Cr.

12. Segment de piston selon l'une des revendications 1 à 11, **caractérisé en ce que** la couche de protection contre l'usure est appliquée au moyen d'un procédé de dépôt physique en phase vapeur (PVD).

13. Segment de piston selon l'une des revendications 1 à 12, **caractérisé en ce que** la couche de protection contre l'usure est appliquée au moyen d'un procédé de dépôt à l'arc réactif.

14. Segment de piston selon l'une des revendications 1 à 13, **caractérisé en ce que** la couche de protection contre l'usure est appliquée au moyen d'un procédé de dépôt chimique en phase vapeur (CVD).

15. Utilisation d'un segment de piston avec une couche de protection contre l'usure selon l'une des revendications 1 à 14 dans des moteurs à essence ou dans des moteurs diesel.
